# FASCICULE DE BREVET EUROPEEN

(11) **EP 0 622 474 B1**
(45) Date de publication et mention de la délivrance du brevet: **17.12.1997**
(21) Numéro de dépôt: 94400916.6
(22) Date de dépôt: 28.04.1994
(51) Int. Cl.: C23C 16/40, C23C 16/44, C23C 16/54

(54) **Procédé pour créer un dépôt d'oxyde de silicium sur un substrat solide en défilement**
Verfahren zur kontinuierlichen Siliciumoxidbeschichtung auf festen Trägern
Continuous process for making a silica coating on a solid substrate

(30) Priorité: 29.04.1993 FR 9305063
(43) Date de publication de la demande: 02.11.1994
(73) Titulaire: L'AIR LIQUIDE, SOCIETE ANONYME POUR L'ETUDE ET L'EXPLOITATION DES PROCEDES GEORGES CLAUDE, 75321 Paris Cédex 07 (FR); SOFTAL electronic GmbH, D-22047 Hamburg (DE)
(72) Inventeur: Slootman, Frank, F-78210 Saint Cyr l'Ecole (FR); Bouard, Pascal, F-91210 Draveil (FR); Coeuret, François, F-78280 Guyancourt (FR); Jouvaud, Dominique, F-75015 Paris (FR); Prinz, Eckhard, c/o Softal Electronic GmbH, D-22047 Hamburg (DE)
(74) Mandataire: Le Moenner, Gabriel

(56) Documents cités:
- EP-A- 0 478 174
- WO-A-91/17561
- WO-A-92/11312
- WO-A-93/06258
- DE-A- 4 142 877
- GB-A- 1 149 052
- SOLID STATE TECHNOLOGY, vol.16, no.11, Novembre 1973 pages 37 - 42 W.C. BENZING ET AL 'A PRODUCTION REACTOR FOR CONTINOUS DEPOSITION OF SILICON OXIDE'
- PATENT ABSTRACTS OF JAPAN vol. 8, no. 15 (C-206) (1452) 21 Janvier 1984 & JP-A-58 181 865 (CITIZEN TOKEI KK) 24 Octobre 1983
- PATENT ABSTRACTS OF JAPAN vol. 7, no. 40 (E-159) 17 Février 1983 & JP-A-57 192 032 (HITACHI SEISAKUSHO KK) 26 Novembre 1982

## Description

La présente invention est relative à un procédé de dépôt d'oxyde de silicium, sur un substrat solide en défilement, notamment un substrat de substance polymère, plus spécialement une polyoléfine.

Les films polymères tels que les polyoléfines sont couramment utilisés dans l'industrie de l'emballage. Toutefois, ces matériaux présentent des propriétés de surface qui les rendent inaptes à l'adhésion et au mouillage. Leur faible mouillabilité, provenant de leur inertie chimique, rend difficile l'étalement des adhésifs et des encres.

Différents traitements industriels on été développés pour pallier les insuffisances de ces matériaux. On peut citer les traitements en phase liquide (sulfochromique), par décharge électrique (décharge couronne ou plasma) ou par flamme. La particularité de ces traitements est de conduire à une oxydation superficielle du matériau. Ainsi, il est possible de créer à la surface de ces matériaux des groupements fonctionnels alcool, aldéhyde, cétone, carboxyle... Cependant, on assiste à une perte des propriétés de surface dans le temps par suite des réarrangements moléculaires dus à une minimalisation de l'énergie de surface. Les groupements polaires responsables des forces d'interaction ont tendance à se retourner vers l'intérieur du matériau. Il s'ensuit que la surface retrouve partiellement sa composition initiale et donc ses propriétés d'origine.

Il est connu qu'on peut améliorer les performances des pellicules de polyoléfine par dépôt sur leur surface d'une faible quantité d'oxyde de silicium. En particulier, le documents WO-A-92/11312, au nom de L'Air Liquide S.A. décrit un procédé selon lequel on soumet un substrat en matériau polymère à une décharge électrique à barrière diélectrique à une pression supérieure à 10000 Pa, et, simultanément ou postérieurement, on expose le substrat ainsi traité à une atmosphère contenant un silane. Un dépôt d'oxyde de silicium se forme par réaction du silane avec l'oxygène résiduel présent à la surface du substrat ou dans l'atmosphère de traitement, ou encore par post-oxydation du dépôt de silicium lorsque le substrat est remis en contact avec l'air.

Dans ce document, il est spécifié que, par "dépôt d'oxyde de silicium", on entend un dépôt de dioxyde de silicium pouvant contenir aussi un oxyde de silicium sous-stoechiométrique en oxygène.

Plus précisément, le procédé dont on vient de parler peut être mis en oeuvre selon deux modes différents:

Selon le premier mode, le traitement par décharge électrique est réalisé en présence d'air, d'azote, d'oxygène, d'argon ou d'un mélange de ces gaz, et on expose ensuite la surface qui a subi la décharge électrique à une atmosphère contenant du silane dilué dans un gaz inerte tel que l'argon, la concentration du silane étant de préférence de 0,01 à 5% en volume, l'atmosphère étant à pression atmosphérique et à température ambiante.

Selon le deuxième mode de mise en oeuvre du procédé, le substrat est soumis au traitement par décharge électrique alors qu'il se trouve dans une atmosphère contenant le silane, par exemple un mélange d'azote, d'argon et de-silane, et ensuite remis au contact de l'air.

Il est précisé que la présence d'un peu d'air dans l'atmosphère contenant le silane, dans l'un ou l'autre de ces deux modes opératoires, peut être tolérée.

Le procédé décrit dans ce document fournit un dépôt d'oxyde de silicium efficace. Cependant, les Demandeurs ont pu constater que le dépôt n'était pas suffisamment régulier sur toute la surface du substrat traité, ce qui peut conduire à des propriétés de surface non homogènes. Il est donc apparu une demande pour une régularité plus parfaite pour ce dépôt à la surface du substrat. Les études qui ont abouti à l'invention ont montré que la voie pour une amélioration de la régularité passait par un meilleur contrôle des teneurs en oxygène de l'atmosphère contenant le silane.

Lorsqu'on effectue le traitement en ligne (roll-to-roll), le substrat défile dans une station où il est soumis à la décharge électrique et exposé à l'atmosphère de silane. La quantité d'air (couche limite) entraînée par le substrat dans la station dépend directement de la vitesse de défilement. Lorsqu'on change la vitesse de défilement, la teneur résiduelle en oxygène varie, ainsi que les paramètres de dépôt.

Un mauvais contrôle de l'atmosphère pourra également conduire à une réaction du silane avec l'oxygène en phase gazeuse en dehors de la zone active avec apparition de particules de silice qui se déposeront sur le substrat ou les parois de la station de traitement (encrassement).

La présente invention a pour but de résoudre ces problèmes, et de fournir un procédé permettant l'obtention de substrats pourvus d'un dépôt d'oxyde de silicium ayant une régularité supérieure à ce qui est obtenu jusqu'ici.

Pour obtenir ce résultat, l'invention fournit un procédé pour créer un dépôt d'oxyde de silicium sur un substrat solide en défilement, selon lequel on soumet le substrat à une décharge électrique à barrière diélectrique en présence d'une atmosphère contenant un silane, cette atmosphère étant à une pression supérieure à 10000 Pa, caractérisé en ce qu'on fait circuler, dans la zone où se produit la décharge électrique, une atmosphère de composition contrôlée contenant un silane et de l'oxygène ou un gaz susceptible de fournir de l'oxygène, ainsi qu'un gaz porteur, et l'on met en oeuvre des moyens pour empêcher substantiellement tout entraînement d'oxygène autre que celui constitutif de la dite atmosphère dans ladite zone.

Dans le cadre de la présente invention, on entend par "silane", un composé sous forme gazeuse dans les conditions de pression et de températures mises en oeuvre, et incluant au moins un atome de silicium. Un silane selon l'invention peut donc consister en un hydrure de silicium de formule SiₙH₂ₙ₊₂, n étant une entier habituellement compris entre 1 et 5, un hydrure de silicium halogéné, tels SiCl₄, SiH₂Cl₂, SiH₃Cl, SiHCl₃, un alkoxysilane tel le tétra-éthoxysilane ou un autre organosiloxane, tel que l'hexaméthyldisiloxane.

Les hydrures de silicium, tels SiH₄, ou Si₂H₆ sont préférés. SiH₄ est tout particulièrement préféré.

Le traitement par décharge électrique à barrière diélectrique consiste à produire une décharge électrique entre deux électrodes, dont l'une au moins est recouvert d'un matériau diélectrique, tel le verre, l'alumine ou la silice, ou, ici le cas échéant, le substrat à traiter. Un tel traitement est classique et connu en lui-même. Il peut notamment consister en une décharge luminescente ou "silent glow discharge" ou, de préférence, en une décharge couronne, bien connue en elle-même, voir par exemple l'article "The flexible adaptation of the effective contact surface", de E. Prinz, paru dans "Plastics Southern Africa", juin 1983, pages 50 et suivantes.

La décharge électrique à barrière diélectrique se fait avantageusement à une pression comprise entre 50000 et 120000 Pa, et de préférence à la pression atmosphérique, la température étant de préférence l'ambiante, ou, généralement, comprise entre l'ambiante et la température de fusion du substrat traité.

La durée de contact du substrat traité par la décharge électrique avec l'atmosphère contenant le silane n'est pas critique et peut notamment être choisie en fonction de l'épaisseur du dépôt d'oxyde de silicium désirée. A titre indicatif, elle peut aller de 10-³ seconde à 1 minute ou plus.

Le procédé de l'invention peut être mis en oeuvre en ligne avec l'installation (par extrusion ou extrusion-soufflage par exemple) de fabrication de substrat en matériau polymère, ou être mis en oeuvre sur un substrat fabriqué et stocké avant traitement. Le substrat peut être par exemple une feuille, ou une pellicule. L'épaisseur du substrat n'est généralement pas critique et peut par exemple être comprise entre 5 µm et 2 cm, plus particulièrement entre 10 et 200 µm.

Le procédé de l'invention est utile pour traiter des substrats en matériaux divers naturels ou synthétiques mais aussi pour traiter des substrats métalliques, notamment des feuilles métalliques telles que des feuilles d'aluminium. A titre de matériau naturel, on peut citer la cellulose, le substrat traité pouvant alors être en papier ou en carton. Toutefois, les substrats en matériau polymère synthétique sont préférés dans le cadre de la présente invention. Parmi ces derniers, les plus avantageux sont en matériau thermoplastique, notamment en polyoléfine, tel le polyéthylène, le polypropylène ou le polystyrène, en polyéthylène téréphtalate, en polyamide, en polychlorure de vinyle ou en polycarbonate. Les substrats en polyoléfines sont tout particulièrement préférés dans le cadre de la présente invention.

Le gaz susceptible de fournir de l'oxygène doit pouvoir fournir de l'oxygène par décomposition sous l'effet de la décharge électrique; il est choisi avantageusement parmi le protoxyde d'azote (N₂O), le monoxyde d'azote (NO) ou le dioxyde de carbone (CO₂). On peut également utiliser la vapeur d'eau (H₂O) ou le méthanol (CH₃OH). Cette liste n'est pas limitative et peut inclure d'autres gaz ou molécules non gazeuses susceptibles de fournir de l'oxygène élémentaire. Un autre gaz avantageux est simplement l'oxygène moléculaire, pouvant être contenu dans l'air ou dans de l'air enrichi, ou appauvri, en oxygène.

Le gaz porteur doit être inerte vis-à-vis du silane. Il peut être choisi dans le groupe constitué par l'azote, l'hélium, l'argon, le néon, le krypton et le xénon.

Suivant un premier mode opératoire, on prépare à l'avance un mélange contenant le silane et l'oxygène ou le gaz susceptible de fournir de l'oxygène, et on introduit ce mélange dans la zone où se produit la décharge électrique.

On observera que pour des raisons de sécurité, le silane et l'oxygène doivent être mélangés juste avant d'être introduits dans la zone où se produit la décharge électrique. Le mélange peut donc se faire dans une conduite d'amenée.

Suivant un second mode opératoire, on introduit séparément, dans la zone où se produit la décharge électrique, le silane et l'oxygène ou le gaz susceptible de fournir de l'oxygène.

Le premier mode opératoire assure une composition de l'atmosphère dans la zone de décharge électrique plus homogène que le second mode opératoire. En revanche, il augmente les risques d'incidents dus à une réaction non contrôlée entre le silane et l'oxygène ou le gaz susceptible de fournir de l'oxygène. Il est donc à éviter si on utilise des corps réactifs, en particulier l'oxygène moléculaire. Dans le cadre de la présente invention, on entend plus particulièrement par "atmosphère contrôlée", une atmosphère dont les teneurs en silane et en oxygène ou gaz susceptible de fournir de l'oxygène, sont prédéterminées. La teneur en silane dans cette atmosphère peut être comprise entre 0,01 et 5% en volume. Le rapport entre les débits de silane et d'oxygène ou gaz susceptible de fournir de l'oxygène n'est pas critique, mais, de préférence, il est tel que la proportion de silane soit inférieure à la proportion stoechiométrique correspondant à l'obtention de dioxyde de silicium. Ainsi, dans la cas où on utilise SiH₄ et N₂O (rapport N₂O/SiH₄ = 1/2 pour la stoechiométrie), le rapport SiH₄/N₂O est habituellement compris entre 1 et 50, et de préférence entre 2 et 10.

Les moyens pouvant être mis en oeuvre pour empêcher substantiellement tout entraînement d'oxygène autre que l'oxygène éventuellement constitutif de l'atmosphère dans la zone où se produit la décharge électrique sont plus particulièrement destinés à empêcher l'entraînement d'air par le substrat en défilement. Ces moyens consistent notamment en des sas d'inertage, des conduites d'aspiration munies de pompes ou de ventilateurs, ou des moyens mécaniques tels des brosses ou des rouleaux entre lesquels défile le substrat. Ces moyen peuvent être disposés en amont et en aval de ladite zone.

La vitesse de défilement du substrat solide est habituellement supérieure à 1 mètre par minute, de préférence comprise entre 30 et 800 mètres par minute.

L'invention fournit encore un dispositif pour la mise en oeuvre du procédé indiqué ci-dessus, et destiné plus particulièrement au traitement en continu d'une bande de polyoléfine. Ce dispositif comprend :
- une électrode ou un groupe d'électrodes susceptibles d'être portées à haute tension électrique par rapport à une contre-électrode située à faible distance de ladite électrode ou groupe d'électrodes, le substrat défilant entre l'électrode ou le groupe d'électrodes et la contre-électrode ;
- un support portant l'électrode ou le groupe d'électrodes pourvu d'un ou plusieurs conduits d'injection disposés pour acheminer un mélange contenant du silane, de l'oxygène ou un gaz susceptible de fournir de l'oxygène, et un gaz porteur, ou des composants de ce mélange ;
- et au moins deux conduits d'aspiration reliés à une source d'aspiration et débouchant l'un en amont et l'autre en aval du ou des conduits d'injection et de l'électrode ou groupe d'électrodes.

La disposition décrite permet d'éviter, ou tout au moins de limiter au minimum, tout entraînement d'air dans la zone de décharge électrique, et d'assurer ainsi une grande stabilité de la composition contrôlée.

Le dispositif selon l'invention permet de faire déboucher les conduites d'injection à des endroits variables et choisis du groupe d'électrodes ou de l'espace où défile le substrat, qu'il s'agisse:
- de l'espace où défile le substrat, au voisinage immédiat de l'électrode (ou groupe d'électrodes) et en amont de celle-ci (ou de celui-ci) si l'on considère le sens de défilement du substrat;
- de l'espace où défile de substrat, situé entre le groupe d'électrodes et la contre-électrode, en faisant transiter ces conduits d'injection à l'intérieur du groupe d'électrodes; ou encore
- au voisinage du groupe d'électrodes ou au sein de ce groupe d'électrodes.

En correspondance aux deux modes opératoires indiqués plus haut, on prévoit que soit le ou les conduits d'injection sont reliés à un conduit unique d'amenée de mélange contenant du silane et de l'oxygène ou un gaz susceptible de former de l'oxygène ne réagissant pas avec le silane dans les conditions de traitement, en l'absence de la décharge électrique, soit que le dispositif comprend au moins deux conduits d'injection dont l'un est relié à une source de gaz contenant du silane et l'autre à une source d'oxygène ou de gaz susceptible de fournir de l'oxygène susceptible de réagir avec ledit silane dans les mêmes conditions.

Le type d'électrode utilisé pour la mise en oeuvre de l'invention pourra consister en toute électrode classiquement utilisée pour la formation d'une décharge électrique à barrière diélectrique, de géométrie donnant lieu à une section électrode par exemple circulaire, ou encore carrée ou rectangulaire.

Les électrodes peuvent ainsi être constitués de métaux non oxydables tels que aluminium anodisé, titane ou préférentiellement l'acier inoxydable, ou encore de céramique (préférentiellement l'alumine), ou un verre.

L'invention va maintenant être exposée de façon plus détaillée à l'aide d'exemples pratiques illustrés avec les dessins parmi lesquels :
- la figure 1 est une vue en coupe et en élévation schématique d'un dispositif de traitement de bande de polyoléfine conforme à l'invention;
- la figure 2 est une vue partielle, correspondant à la figure 1, et montrant une variante;
- la figure 3 est un diagramme de variation de tension superficielle en fonction du temps.
- la figure 4 est une représentation schématique d'une variante du dispositif de la figure 1, pour laquelle le mélange gazeux est introduit directement dans l'espace entre le système d'électrodes et la contre-électrode.
- la figure 5 est une représentation schématique d'une variante du dispositif de la figure 2, pour laquelle les deux mélanges gazeux sont introduits séparément et directement dans l'espace entre le système d'électrodes et la contre-électrode.
- la figure 6 représente une variante du dispositif de la figure 4, pour laquelle le système d'électrodes comprend seulement deux électrodes.
- la figure 7 représente une variante du dispositif de la figure 6, pour laquelle les deux électrodes du système sont de section rectangulaire.

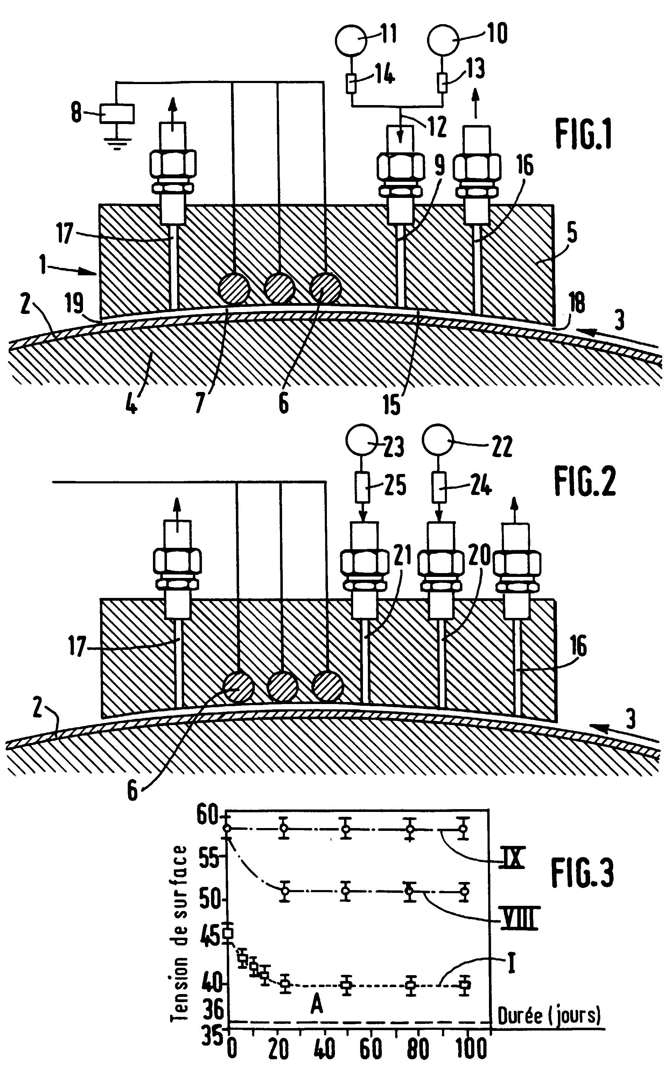

La figure 1 montre un dispositif de traitement 1 qui est traversé par exemple par une bande de polyoléfine à traiter 2, dans le sens de la flèche 3.

La bande 2 est portée par une contre-électrode constituée par un tambour 4, qui tourne dans le sens indiqué par la flèche 3. Au-dessus de la contre-électrode 4 est disposé un support 5 qui maintient des électrodes 6 de façon à laisser entre ces électrodes et la contre-électrode, un intervalle 7 d'épaisseur bien définie, un peu supérieure à l'épaisseur de la bande 2.

Les électrodes 6 sont reliées à une source de très haute tension et haute fréquence 8, alors que la contre-électrode est à la masse.

Le support 5 est traversé par un conduit d'injection 9 relié à une source 10 de mélange d'azote, formant le gaz porteur et de silane, et une source 11 par exemple d'un mélange de N₂O et d'azote (ou encore d'oxygène ou d'un gaz susceptible de fournir de l'oxygène), par un conduit d'amenée commun 12.

Des moyens de contrôle 13, 14 sont prévus pour mesurer et régler le débit des sources 10 et 11.

Le conduit d'injection 9 débouche dans l'intervalle 15 entre le support 5 et la contre-électrode 4 à faible distance en amont des électrodes 6. L'amont, comme l'aval, sont définis en se référant au sens de défilement indiqué par la flèche 3.

En amont et en aval du conduit d'injection 9, débouchent deux conduits d'aspiration 16 et 17, qui traversent également le support 5, et sont reliés à un dispositif d'aspiration non représenté.

Les conduits d'aspiration 16 et 17 débouchent dans l'intervalle 15, le premier entre le point 18 où la bande 2 pénètre dans cet intervalle, et le conduit d'injection 9, et le second entre les électrodes 6 et le point 19 où la bande sort de l'intervalle 15.

On précise ici que les conduits d'injection et d'aspiration sont constitués par des fentes transversales, dont la longueur est au moins égale à la largeur de la bande 2. Il existe, autour des électrodes 6, une atmosphère dont la composition est extrêmement voisine de celle du gaz envoyé par le conduit 9. On obtient donc une parfaite régularité des conditions opératoires, et l'expérience montre qu'on obtient également une excellente régularité du résultat.

La figure 2 montre une variante de la disposition décrite à la figure 1. La variante consiste essentiellement dans le fait que le conduit d'injection 9 de la figure 1 est remplacé par deux conduits d'injection 20, 21, reliés l'un à une source 22 d'un mélange de silane et de gaz neutre, argon ou azote, et l'autre à une source 23 d'un mélange d'air, ou un autre gaz oxydant, et de gaz neutre, air ou azote. Les proportions respectives de silane et d'oxygène sont contrôlées à l'aide de dispositifs 24, 25, intercalés sur les conduits 20, 21.

Les deux conduits 20 et 21 débouchent au voisinage de la bande 2, un peu en amont des électrodes 6, entre les conduits d'aspiration 16 et 17.

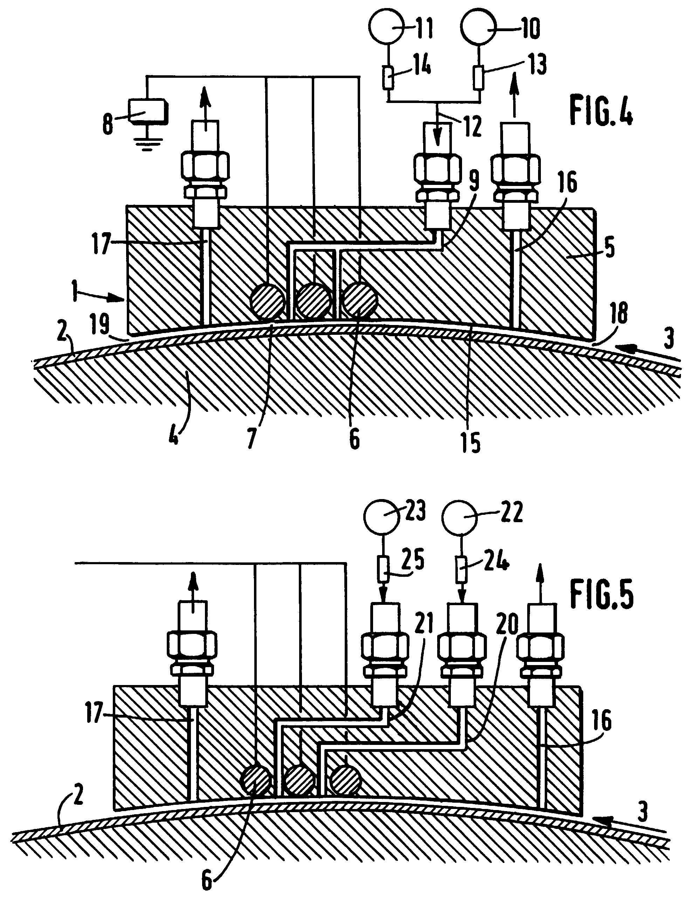

La figure 4 est une représentation schématique d'une variante du dispositif de la figure 1, pour laquelle le mélange gazeux est introduit directement dans l'espace entre le système d'électrodes et la contre-électrode.

La figure 5 est une représentation schématique d'une variante du dispositif de la figure 2, pour laquelle les deux mélanges gazeux sont introduits directement dans l'espace entre le système d'électrodes et la contre-électrode.

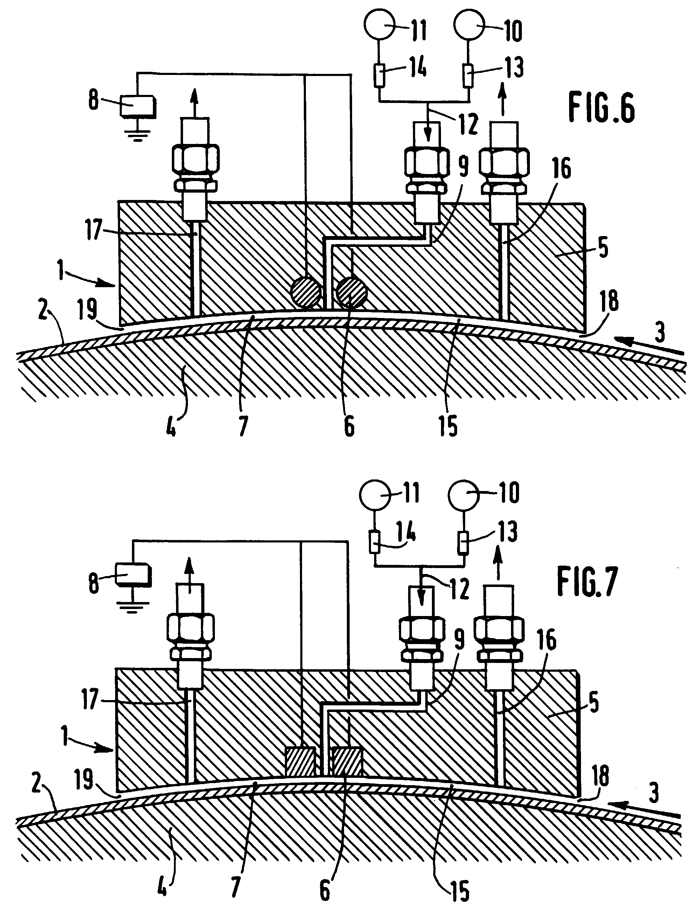

La figure 6 représente une variante du dispositif du la figure 4, pour laquelle le système d'électrodes comprend seulement deux électrodes.

La figure 7 représente une variante du dispositif de la figure 6, pour laquelle les deux électrodes du système sont de section rectangulaire.

Les essais réalisés avec l'un ou l'autre des appareillages ci-dessus ont permis d'observer que, contrairement à ce qui est suggéré dans le document WO-A-92/11312, l'efficacité du procédé décroît très fortement lorsqu'on utilise un mélange d'argon et de silane à teneur extrêmement faible en oxygène.

En l'absence des dispositions prévues par la présente invention, il semble que des résultats corrects, mais nécessairement irréguliers, ne sont obtenus que grâce à la présence d'air entraîné par la feuille en défilement.

On donne ci-après des résultats d'essais dans les conditions suivantes :
- atmosphère au voisinage des électrodes 6 :
   . composition : variable, voir ci-après ;
   . débit: 10 Nl/minute ;
   . densité de traitement : 40 Wmn/m² ;
   . vitesse de défilement : 33 m/minute ;
   . distance entre électrode et contre-électrode : 1,5 mm;
   . nature du substrat : Mobil Bicor MB 400 (marque déposée). Il s'agit d'une feuille de polypropylène bi-orientée co-extrudée d'épaisseur 20 micromètres et de largeur 0,3 m. Sa tension de surface initiale est inférieure à 36 mN/m.
   . mesures de tension superficielle : effectuées selon la norme ASTM-D-2578-84 sur des échantillons non lavés, immédiatement après le traitement. La valeur maximale mesurables est 58 mN/m, et l'erreur de mesure est estimée à ± 1 mN/m.

Les résultats des essais sont donnés par le tableau ci-après :

| ESSAI | SiH4 | Oxydant | Gaz neutre | Tension de surface |
|---|---|---|---|---|
| non traité | - | - | - | <36 |
| 1 témoin | - | Air | Air | 46 |
| 2 témoin | 0,2% | sans | N₂ ou Ar | 54 |
| 3 invention | 0,2% | N2O : 0,8% | N₂ ou Ar | >58 |
| 4 invention | 0,2% | CO2 : 0,4% | N₂ ou Ar | >58 |
| 5 invention | 0,2% | Air | Air | >58 |
| 6 invention | 0,5% | Air | Air | >58 |
| 7 invention | 0,2% | 0₂ : 2% | Argon | >58 |
| 8 invention | 0,2% | N₂O : 0,8% | Argon | >58 |
| 9 invention | 0,5% | N₂O : 2,0% | Argon | >58 |

Dans le cas de l'exemple 7, les débits étaient : Argon 10 Nl/minute, oxygène : 200 cm³/minute.

La figure 3 montre l'évolution de la tension de surface en fonction du temps. Les courbes I, VIII et IX correspondent respectivement aux échantillons des essais 1 (témoin), 8 et 9 (conformes à l'invention). La droite A est relative au produit non traité.

On constate que le contrôle de l'atmosphère au voisinage de la zone des électrodes permet une amélioration des propriétés de tension superficielle et de vieillissement du produit.

## Revendications

1. Procédé pour créer un dépôt d'oxyde de silicium sur un substrat solide en défilement, selon lequel on soumet le substrat à une décharge électrique à barrière diélectrique en présence d'une atmosphère contenant un silane, cette atmosphère étant à une pression supérieure à 10000 Pa, caractérisé en ce qu'on fait circuler, dans la zone où se produit la décharge électrique, un atmosphère de composition contrôlée contenant un silane et de l'oxygène ou un gaz susceptible de fournir de l'oxygène, ainsi qu'un gaz porteur, et l'on met en oeuvre des moyens pour empêcher substantiellement tout entraînement d'oxygène autre que celui constitutif de ladite atmosphère dans ladite zone.

2. Procédé selon la revendication 1, caractérisé en ce que le gaz susceptible de fournir de l'oxygène est choisi parmi N₂O, NO et CO₂ ou leurs mélanges.

3. Procédé selon la revendication 1 ou 2, caractérisé en ce que le gaz susceptible de fournir de l'oxygène est choisi parmi H₂O, ou le méthanol ou leurs mélanges.

4. Procédé selon la revendication 1, caractérisé en ce que l'atmosphère contient de l'oxygène moléculaire.

5. Procédé selon l'une des revendications 1 à 4, caractérisé en ce qu'on prépare à l'avance un mélange contenant le silane et l'oxygène ou le gaz susceptible de fournir de l'oxygène, et on introduit ce mélange dans la zone où se produit la décharge électrique.

6. Procédé selon l'une des revendications 1 à 4, caractérisé en ce qu'on introduit séparément, dans la zone où de produit la décharge électrique, le silane, et l'oxygène ou le gaz susceptible de fournir de l'oxygène.

7. Procédé selon l'une des revendications 1 à 6, caractérisé en ce que le substrat est un polymère.

8. Procédé selon la revendication 7, caractérisé en ce que le substrat est un polyéofine.

9. Procédé selon l'une des revendications 1 à 6, caractérisé en ce que le substrat est en papier ou en carton.

10. Procédé selon l'une des revendications 1 à 6, caractérisé en ce que le substrat est métallique.

11. Dispositif pour la mise en oeuvre du procédé selon l'une des revendications 2 à 10, caractérisé en ce qu'il comprend:
- une électrode ou un groupe d'électrodes (6) susceptible d'être portée à haute tension électrique par rapport à une contre-électrode située à faible distance de ladite électrode ou groupe d'électrodes, le substrat défilant entre l'électrode ou groupe d'électrodes et la contre-électrode ;
- un support portant l'électrode ou le groupe d'électrodes pourvu d'un ou plusieurs conduits d'injection (9, 20, 21) disposés pour acheminer un mélange contenant du silane, de l'oxygène ou un gaz susceptible de fournir de l'oxygène, et un gaz porteur, ou des composants de ce mélange,
- et au moins deux conduits d'aspiration (16, 17) débouchant l'un en amont et l'autre en aval du ou des conduits d'injection et de l'électrode ou groupe d'électrodes.

12. Dispositif selon la revendication 11, caractérisé en ce que le ou les conduits d'injection débouchent dans l'espace où défile le substrat, au voisinage de l'électrode ou du groupe d'électrodes et en amont de celle-ci ou celui-ci si l'on considère le sens (3) de défilement du substrat.

13. Dispositif selon la revendication 11, caractérisé en ce que le ou les conduits d'injection débouchent dans l'espace où défile le substrat, entre l'électrode ou le groupe d'électrodes et la contre-électrode.

14. Dispositif selon la revendication 11 caractérisé en ce que le ou les conduits d'injection débouchent au voisinage supérieur de l'électrode ou du groupe d'électrodes ou entre les électrodes.

15. Dispositif selon l'une des revendications 11 à 14, caractérisé en ce que le conduit d'injection (9) est relié à un conduit unique (12) d'amenée de mélange contenant un silane et de l'oxygène ou un gaz susceptible de fournir de l'oxygène et ne réagissant pas avec le silane dans les conditions du traitement, en l'absence de la décharge électrique.

16. Dispositif selon lune des revendications 11 à 14, caractérisé en ce qu'il comprend au moins deux conduits d'injection (20, 21) dont l'un est relié à une source (22) de gaz contenant du silane et l'autre à une source de gaz (23) contenant de l'oxygène ou un gaz susceptible de fournir de l'oxygène, susceptible de réagir avec ledit silane dans les conditions du traitement, en l'absence de la décharge électrique.

## Patentansprüche

1. Verfahren zum Erzeugen einer Siliciumoxidschicht auf einen sich bewegenden, festen Substrat, bei dem das Substrat einer elektrischen Entladung über einen dielektrischen Widerstand in Anwesenheit einer Silan enthaltenden Atmosphäre ausgesetzt wird, wobei diese Atmosphäre einen Druck von mehr als 10000 Pa aufweist, dadurch gekennzeichnet, daß man in dem Bereich, in dem die elektrische Ladung erfolgt, eine ein Silan und Sauerstoff oder ein Sauerstoff abgebendes Gas sowie ein Trägergas enthaltende Atmosphäre strömen läßt und Einrichtungen einsetzt, die jedes Mitschleppen von Sauerstoff im wesentlichen verhindern außer dem Sauerstoff, der Bestandteil der Atmosphäre in der Zone ist.

2. Verfahren nach Anspruch 1, dadurch gekennzeichnet, daß das Sauerstoff abgebende Gas unter N₂O, NO und CO₂ oder deren Mischungen ausgewählt wird.

3. Verfahren nach Anspruch 1 oder 2, dadurch gekennzeichnet, daß das Sauerstoff abgebende Gas zwischen H₂O, Methanol oder ihren Mischungen ausgewählt wird.

4. Verfahren nach Anspruch 1, dadurch gekennzeichnet, daß die Atmosphäre molekularen Sauerstoff enthält.

5. Verfahren nach einem der Ansprüche 1 bis 4, dadurch gekennzeichnet, daß die Silan und Sauerstoff oder ein Sauerstoff abgebenden Gas enthaltende Mischung im voraus hergestellt und diese Mischung in die Zone, wo die elektrische Entladung stattfindet, eingeführt wird.

6. Verfahren nach einem der Ansprüche 1 bis 4, dadurch gekennzeichnet, daß das Silan, der Sauerstoff oder das Sauerstoff abgebende Gas voneinander getrennt in die Zone, wo die elektrische Entladung stattfindet, eingeführt werden.

7. Verfahren nach einem der Ansprüche 1 bis 6, dadurch gekennzeichnet, daß das Substrat ein Polymer ist.

8. Verfahren nach Anspruch 7, dadurch gekennzeichnet, daß das Substrat ein Polyolefin ist.

9. Verfahren nach einem der Ansprüche 1 bis 6, dadurch gekennzeichnet, daß das Substrat Papier oder Karton ist.

10. Verfahren nach einem der Ansprüche 1 bis 6, dadurch gekennzeichnet, daß das Substrat ein Metall ist.

11. Vorrichtung zur Durchführung des Verfahrens gemäß einem der Ansprüche 2 bis 10, dadurch gekennzeichnet, daß sie folgende Elemente aufweist:
- eine Elektrode oder eine Elektrodengruppe (6), die sich auf eine hohe elektrische Spannung mit Bezug auf eine mit geringem Abstand zur Elektrode oder Elektrodengruppe angeordnete Gegenelektrode bringen läßt, wobei sich das Substrat zwischen der Elektrode oder Elektrodengruppe und der Gegenelektrode bewegt;
- ein Träger, der die Elektrode oder die Elektrodengruppe hält und eine oder mehrere Einstrahlleitungen (9, 20, 21) zum Heranführen einer Mischung, die Silan, Sauerstoff oder ein Sauerstoff abgebendes Gas und ein Trägergas, oder Bestandteile dieser Mischung
- und wenigstens zwei Ansaugleitungen (16, 17), wovon eine stromauf und die andere stromab von der oder den Einstrahlleitungen und der Elektrode oder der Elektrodengruppe münden, aufweist.

12. Vorrichtung nach Anspruch 11, dadurch gekennzeichnet, daß die Einstrahlleitung oder Einstrahlleitungen in den Raum, durch den sich das Substrat bewegt in der Nachbarschaft der Elektrode oder der Elektrodengruppe münden und zwar stromauf von dieser oder diesen mit Bezug auf die Bewegungsrichtung (3) des Substrats.

13. Vorrichtung nach Anspruch 11, dadurch gekennzeichnet, daß die Einstrahlleitung oder die Einstrahlleitungen in den Raum, durch den sich das Substrat bewegt zwischen der Elektrode oder der Elektrodengruppe und der Gegenelektrode münden.

14. Vorrichtung nach Anspruch 11, dadurch gekennzeichnet, daß die Einstrahlleitungen in der oberen Nachbarschaft der Elektrode oder der Elektrodengruppe oder zwischen den Elektroden münden.

15. Vorrichtung nach einem der Ansprüche 11 bis 14, dadurch gekennzeichnet, daß die Einstrahlleitungen (9) mit einer einzigen Zufuhrleitung (12) für die ein Silan und Sauerstoff oder ein Sauerstoff abgebendes Gas enthaltenden Mischung, die nicht mit dem Silan unter den Behandlungsbedingungen in Abwesenheit der elektrischen Entladung reagieren, verbunden ist.

16. Vorrichtung nach einem der Ansprüche 11 bis 14, dadurch gekennzeichnet, daß sie wenigstens zwei Einstrahlleitungen (20, 21) umfaßt, von denen die eine mit einer Silan enthaltenden Gasquelle und die andere mit einer Sauerstoff oder ein Sauerstoff abgebendes Gas enthaltenden Gasquelle (23), die mit dem Silan unter den Behandlungsbedingungen in Abwesenheit der elektrischen Ladung reagieren, verbunden ist.

## Claims

1. Process for creating a deposit of silicon oxide on a moving solid substrate, according to which the substrate is subjected to a dielectric barrier electric discharge in the presence of an atmosphere containing a silane, this atmosphere being at a pressure greater than 10 000 Pa, characterized in that there is circulated, in the zone where the electric discharge is produced, an atmosphere with a controlled composition containing a silane and oxygen or a gas capable of providing oxygen, as well as a carrier gas, and in that means are used for substantially preventing any entrainment of oxygen other than that which constitutes the said atmosphere in the said zone.

2. Process according to claim 1, characterized in that the gas capable of providing oxygen is selected from N₂O, NO and CO₂ or mixtures thereof.

3. Process according to claim 1 or 2, characterized in that the gas capable of providing oxygen is selected from H₂O or methanol or mixtures thereof.

4. Process according to claim 1, characterized in that the atmosphere contains molecular oxygen.

5. Process according to one of claims 1 to 4, characterized in that a mixture is prepared in advance containing silane and oxygen or the gas capable of providing oxygen, and this mixture is introduced into the zone where the electric discharge is produced.

6. Process according to one of claims 1 to 4, characterized in that silane and oxygen or the gas capable of providing oxygen are introduced separately into the zone where the electric discharge is produced.

7. Process according to one of claims 1 to 6, characterized in that the substrate is a polymer.

8. Process according to claim 7, characterized in that the substrate is a polyolefin.

9. Process according to one of claims 1 to 6, characterized in that the substrate is made of paper or cardboard.

10. Process according to one of claims 1 to 6, characterized in that the substrate is metallic.

11. Device for putting the process according to one of claims 2 to 10 into practice, characterized in that it comprises :
- an electrode or a group of electrodes (6) capable of being raised to a high electrical voltage with respect to a counter-electrode situated a short distance from the said electrode or group of electrodes, the substrate moving between the electrode or group of electrodes and the counter-electrode;
- a support carrying the electrode or group of electrodes provided with one or more injection pipes (9, 20, 21) arranged so as to convey a mixture containing silane, oxygen or a gas capable of providing oxygen, and a carrier gas, or components of this mixture;
- and at least two extraction pipes (16, 17) emerging one upstream and the other downstream from the injection pipe or pipes and the electrode or group of electrodes.

12. Device according to claim 11, characterized in that the injection pipe or pipes emerge(s) in the space through which the substrate passes, in the vicinity of the electrode or group of electrodes and upstream from these in relation to the direction of movement (3) of the substrate.

13. Device according to claim 11, characterized in that the injection pipe or pipes emerge(s) in the space through which the substrate passes, between the electrode or group of electrodes and the counter-electrode.

14. Device according to claim 11, characterized in that the injection pipe or pipes emerge(s), in the upper vicinity of the electrode or group of electrodes or between the electrodes.

15. Device according to one of claims 11 to 14, characterized in that the injection pipe (9) is connected to a single pipe (12) conveying the mixture containing silane and oxygen or a gas capable of providing oxygen and not reacting with silane under the treatment conditions, in the absence of the electric discharge.

16. Device according to one of claims 11 to 14, characterized in that it comprises at least two injection pipes (20, 21) one of which is connected to a source (22) of gas containing silane and the other to a source of gas (23) containing oxygen or a gas capable of providing oxygen, capable of reacting with the said silane under the treatment conditions, in the absence of the electric discharge.
